# EUROPÄISCHE PATENTANMELDUNG

(11) **EP 3 712 624 A1**
(43) Veröffentlichungstag der Anmeldung: **23.09.2020**
(21) Anmeldenummer: 20164542.1
(22) Anmeldetag: 20.03.2020
(51) Int. Cl.: G01R 19/25

(54) **VERFAHREN ZUM ÜBERWACHEN EINES TECHNISCHEN GERÄTS**

(30) Priorität: 21.03.2019 DE 102019203900
(71) Anmelder: Robert Bosch GmbH, 70442 Stuttgart (DE)
(72) Erfinder: Ulrich, Markus, 70374 Stuttgart (DE); Messer, Serena, 70599 Stuttgart (DE)

(57) **Zusammenfassung**

Verfahren zum Überwachen eines elektrischen Geräts (20), das über einen Adapter (10) mit einem Stromnetz (13) verbunden ist, wobei mindestens ein Rohsignal, das eine Zeitreihe von Messwerten repräsentiert und von dem Adapter (10) bereitgestellt wird, mittels einer trendbereinigten Fluktuationsanalyse (DFA) ausgewertet wird, so dass ein trendbereinigtes Signal erhalten wird, das wiederum ausgewertet wird, um eine zeitliche Veränderung der Fluktuation der Messwerte zu erkennen und diese zeitliche Veränderung auszuwerten.

## Beschreibung

Die Erfindung betrifft ein Verfahren zum Überwachen eines technischen Geräts und eine Anordnung zum Durchführen des Verfahrens.

### Stand der Technik

Die Überwachung technischer Gerät dient dazu, die Betriebsfähigkeit des betreffenden Geräts kontinuierlich oder in typischerweise regelmäßigen Abständen zu überprüfen, um so einen ggf. drohenden Ausfall rechtzeitig zu erkennen und frühzeitig geeignete Maßnahmen einleiten zu können.

Elektrisch betriebene technische Geräte sind in vielen Fällen über einen Adapter mit einem Netzanschluss verbunden und werden von diesem mit elektrischer Energie versorgt. Dies bedeutet, dass die Geräte typischerweise mit einem Stecker an einer Steckdose angeschlossen sind, über die elektrische Energie bereitgestellt wird.

Es sind intelligente bzw. smarte Steckdosen bekannt, die über eine IoT-Anbindung (loT: Internet of Things) mit einem Smartphone oder mit einer Computersteuerung an- und ausgeschaltet werden können. Diese Steckdosen werden eingesetzt, um von einer entfernten Position aus, bspw. mit einem Smartphone oder einem Sprachsteuerungs-Assistenten, Geräte ein- oder auszuschalten und ggf. über eine Steuerung nicht genutzte Geräte abzuschalten. Dies soll bspw. dabei helfen, Energie zu sparen. Neben dem An- und Ausschalten bietet eine solche Steckdose prinzipiell noch die Möglichkeit, die Leistungsaufnahme eines angesteckten Geräts zu messen. Derzeit werden jedoch keine Signale aufgezeichnet oder ausgewertet, so dass grundsätzlich nicht erkannt wird, welches Gerät angesteckt ist oder ob dieses Gerät ggf. defekt ist.

Die Druckschrift DE 10 2015 009 361 A1 beschreibt eine Vorrichtung zur automatischen Detektion eines elektrischen Geräts, das über einen Stecker mit einer intelligenten Steckdose verbunden ist. Der Stecker ist mit einem Funketikett ausgestattet, auf dem Daten des Geräts gespeichert sind. Die intelligente Steckdose verfügt über ein Lesegerät, das Daten des Funketiketts erfasst und zu einer entfernten Datenverarbeitungseinrichtung überträgt.

### Offenbarung der Erfindung

Vor diesem Hintergrund werden ein Verfahren nach Anspruch 1 und eine Anordnung gemäß Anspruch 9 vorgestellt. Ausführungsformen ergeben sich aus den abhängigen Ansprüchen und aus der Beschreibung.

Das vorgestellte Verfahren sieht vor, dass mindestens ein Signal, das in Form einer Zeitreihe aufgezeichnet ist und das von einem Adapter, der einem technischen Gerät zugeordnet ist, bereitgestellt wird, mittels einer trendbereinigten Fluktuationsanalyse bzw. DFA (DFA, engl. Detrended Fluctuation Analysis) analysiert wird. Dies bedeutet, dass der Adapter Daten bzw. Messwerte bereitstellt, die kontinuierlich oder in zeitlichen Abständen gemessen wurden. Diese Daten bzw. Messwerte liegen in der Reihenfolge, in der sie gemessen wurden, vor. Die Zeitreihe mit den in zeitlicher Reihenfolge vorliegenden Messwerten bzw. Daten wird durch das Signal, das von dem Adapter bereitgestellt wird und hierin auch als Rohsignal bezeichnet wird, repräsentiert. Folglich wurde das Signal in Form einer Zeitreihe, die Messwerte in zeitlicher Reihenfolge umfasst, aufgezeichnet.

Um das Signal bzw. die Zeitreihe von Trends zu befreien, wird eine DFA durchgeführt, so dass ein trendbereinigtes Signal erhalten wird, das dann weiter analysiert wird, um eine zeitliche Veränderung der Fluktuation der Daten zu erkennen und auszuwerten. Dabei ist insbesondere vorgesehen, die zeitliche Veränderung der Fluktuation zu nutzen, um auf zukünftige Ereignisse, die das technische Gerät betreffen, schließen zu können.

Unter Fluktuation ist eine kurzzeitige oder andauernde Veränderung, d. h. eine Schwankung bzw. ein Wechsel, von Gegebenheiten und Zuständen, d. h. in diesem Fall in dem Signal bzw. den Signalwerten, zu verstehen. Ein Trend ist eine systematische Zunahme oder systematische Abnahme in einer Zeitreihe. Diese Zeitreihe kann zudem Fluktuation oder periodische Schwingungen aufweisen. Ein Trend bei einem technischen elektrischen Gerät in dessen Leistungsverbrauch kann bspw. durch Tageszeiten bewirkt sein. So verbraucht ein Fernseher als Beispiel für ein technisches Gerät zu Hauptsendezeiten grundsätzlich mehr Energie, da der Fernseher zu diesen Zeiten regelmäßig mehr benutzt wird. Die Auswirkungen solcher Trends sollen nunmehr eliminiert werden, um Fluktuation erfassen bzw. erkennen zu können.

Die Daten bzw. Messwerte, die von dem Adapter bereitgestellt werden, liegen somit als Signal, das in Form einer Zeitreihe aufgezeichnet ist, vor. Zu beachten ist, dass Signale, die in Form einer Zeitreihe aufgezeichnet werden, z. B. mit Methoden einer Zeitreihenanalyse untersucht werden können. Für die Analyse von Korrelationen in Fluktuationen bieten sich für stationäre, d. h. mittelwertstabile Signale, ohne Trends konventionelle Methoden, bspw. die Autokorrelationsfunktion oder eine Fourieranalyse, an.

Es wurde nunmehr erkannt, dass die hierin zu untersuchenden Signale jedoch instationäre, d. h. trendbehaftete, Zeitreihen sind. Es zeigt sich, dass für diese Signale eine trendbereinigende Fluktuationsanalyse geeignet ist.

Es wurde erkannt, dass Fehlfunktionen von Maschinen über die Änderung von Korrelationen in Fluktuationen von Signalen, die von solchen Maschinen aufgenommen werden, frühzeitig erkannt werden können, bevor es zu einem schwerwiegenden Schaden kommt. Eine Anwendung hierfür ist bspw. die Messung des an einer Welle einer Maschine anliegenden Drehmoments. Die Fluktuationen im gemessenen Drehmoment können dann Aufschluss über bevorstehende Schäden, wie bspw. das Ausschlagen einer Welle oder Schädigungen in den Lagern, geben.

Bei dem vorgestellten Verfahren werden Signale, d. h. Verläufe von Daten, die in Zeitreihen vorliegen und die von einem Adapter, der eine Schnittstelle zwischen

Gerät und Stromnetz darstellt, bereitgestellt werden, analysiert. Der Adapter umfasst bspw. einen Stecker und eine Steckdose. In diesem Fall können die Daten von dem Stecker und/oder der Steckdose bereitgestellt werden. Die Auswertung kann ebenfalls in dem Adapter, d. h. in dem Stecker und/oder der Steckdose, oder in einer externen Einheit ausgeführt werden.

Der vorstehend erläuterte Stecker bietet in Ausgestaltung die Möglichkeit, Geräte ferngesteuert an- oder auszuschalten. Prinzipiell kann auch z. B. die Leistungsaufnahme gemessen werden. Es werden derzeit jedoch keine Signale aufgezeichnet, die eine automatische Geräteerkennung ermöglichen. Zuordnungen von Geräten an Steckern und eine entsprechende Identifizierung in einem Haushalt erfolgen derzeit manuell über das Abtasten bzw. Scannen von an dem Stecker angebrachten QR-Codes, die dann in ein intelligentes Hauswirtschaftsystem, das auch als Smart Home Eco-System bezeichnet wird, eingebunden und verwaltet werden. Zeitlich aufgelöste, insbesondere hoch aufgelöste, Signale, wie bspw. die Leistungsaufnahme eines angesteckten Geräts, werden nicht oder zumindest nicht hoch abgetastet aufgenommen und weiter verarbeitet.

Mit der vorgeschlagenen Anordnung bzw. dem beschriebenen Verfahren sollen in einem entsprechend ausgestatteten Adapter Signale, insbesondere auch zeitlich hochaufgelöst, bspw. 1 Wert pro Sekunde oder mehr, aufgezeichnet werden. So kann neben der Leistungsaufnahme z. B. die zeitliche Veränderung der Leistungsaufnahme protokolliert werden. Ebenso ist eine leichte Verschiebung in der Stromfrequenz auflösbar. Diese Signale können aufgezeichnet und analysiert werden.

Zu beachten ist, dass unterschiedliche Geräte unterschiedliche Leistungsaufnahmen haben. Ebenso ist der zeitliche Verlauf der Leistungsaufnahme charakteristisch für bestimmte Geräte. Dies ist ein charakteristisches Merkmal für ein bestimmtes Gerät bzw. einer Geräteklasse, welches einem Gerät zugeordnet und wieder erkannt werden kann. Dies kann z. B. durch ein trainiertes neuronales Netz erfolgen. Ausgehend von diesen Signalen kann somit eine automatische Erkennung des Geräts beim Einstecken bzw. Einschalten erfolgen. Folglich kann der Adapter, bspw. der Stecker, die Information liefern, welches Gerät eingesteckt ist.

Diese Information kann z. B. genutzt werden, um Stromsparfunktionen zu steuern, Geräte hinsichtlich Ihres ordnungsgemäßen Verhaltens zu überwachen und schließlich Schäden an den Geräten oder der Hausleitung, bspw. durch Überspannungen oder Überlastungen, zu vermeiden.

Insbesondere die Erkennung einer drohenden Schädigung kann zweckmäßigerweise bei zeitlich hochaufgelösten Signalen über bspw. eine Fluktuationsanalyse erfolgen. Ändert sich die Korrelation in den Fluktuationen, so ist dies z. B. ein Indikator für einen bevorstehenden Schaden. In diesem Fall kann der Adapter eine Meldung an z. B. ein Smartphone und/oder einen Smart Home Sprachassistenten abgeben und/oder automatisch abschalten.

Der Adapter zeichnet sich dadurch aus, dass er Signale, z. B. die Leistungsaufnahme, den Strom, die Spannung, die Strom- oder Spannungsfrequenz usw., die durch den Betrieb eines Geräts an diesem Stecker entstehen, zeitlich hoch aufgelöst aufzeichnet und diese zu Analysezwecken entweder lokal, bspw. in einem Speicher, oder extern, z. B. in einer IoT Cloud, speichert. Mittels eines geeigneten Analyseverfahrens werden die Daten entweder lokal im Adapter, wenn bspw. der Adapter zweckmäßigerweise mit einem kleinen Rechenprozessor ausgestattet ist, oder in der Cloud, z. B. über einen Cloud Service, ausgewertet und die hieraus gewonnenen Informationen zur weiteren Verarbeitung, z. B. für eine Steuerung von Geräten, zur Verfügung gestellt.

Mit diesem Vorgehen werden Informationen generiert, die zur Erkennung eingesteckter, nicht notwendigerweise IoT fähiger Geräte genutzt und zur optimierten Steuerung von Geräten z. B. in einem Haushalt sowie zur Überwachung dieser Geräte, im Sinne eines intelligenten Home Appliance Management, genutzt werden. Die Analyse der Signale soll für eine Erkennung der Geräte, eine Erkennung von Betriebspunkten sowie eine Erkennung bevorstehender Schäden am Gerät eingesetzt werden.

Das vorgestellte Verfahren ist grundsätzlich dazu geeignet, mehrere Rohsignale und auch Rohsignale von mehreren Geräten auszuwerten. Hierbei kann auch eine Kreuzkorrelation durchgeführt werden. Zur Kreuzkorrelation wird nachstehend ausgeführt:
Liegen gleichzeitige Signale von mehreren Geräten bzw. mehreren Steckern oder ein Signal eines Geräts und ein weiteres Signal einer weiteren Größe, z. B. die Frequenzschwankung oder aber die Spannungsschwankung einer Spannungsversorgung, bspw. einer Steckdose, vor, so können sogenannte Kreuzkorrelationen zwischen jeweiligen Fluktuationen dieser Größen ermittelt werden. Zweckmäßigerweise können diese beiden Signale in einem Stecker gleichzeitig gemessen werden, z. B. durch entsprechende zwei Messschaltungen in einem Stecker, oder auch von zwei, insbesondere räumlich entfernten, Steckern gemessen werden, die dann zweckmäßigerweise bzgl. Ihrer Gleichzeitigkeit zeitlich synchronisiert werden, z. B. durch einen Synchronisierungsimpuls, der durch eine entsprechende Vorrichtung, beispielsweise eine Signalschaltung bzw. einen Signalgenerator, einmalig oder mehrmalig auf das Signal aufgeprägt wird.

Die beiden Signale bzw. Zeitreihen werden dann ggf. mittelwertbereinigt und anschließend analog zur DFA jeweils kumuliert und anschließend jeweils in einem Fenster einer gegebenen Breite mittels eines lokalen Polynomfit trendbereinigt, wobei der lokale Polynomfit von dem jeweiligen Signalabschnitt in dem jeweiligen Fenster abgezogen wird und so das jeweilige Residuum des Zeitabschnitts in dem jeweiligen Fenster ermittelt wird. Diese Residuen der jeweiligen beiden Signale können nun punktweise zum jeweiligen gleichen Wert oder aber punktweise zu einem festgesetzten zeitlichen Abstand voneinander multipliziert werden. Führt man dies zu allen möglichen zeitlichen Abständen innerhalb der Zeitreihe durch und summiert diese punktweisen Produkte der Residuen, so erhält man die sogenannte Kovarianz der beiden Zeitreihen bzw. im Falle der jeweiligen lokalen Trendbereinigung die Kovarianz der beiden Fluktuationen. Die Kovarianz der Fluktuationen zeigt analog zur Fluktuationsfunktion der einzelnen Zeitreihen ein Potenzgesetz, wobei der Exponent angibt, wie stark die Fluktuationen der beiden Zeitreihen ursächlich voneinander abhängen. Das Vorgehen zur Durchführung einer trendbereinigten Kreuzkorrelationsanalyse ist aus der Literatur bekannt (z. B. B. Podobnik, H. E. Stanley, Detrended Cross-Correlated Analysis: A New Method For Analyzing Two Nonstationary Time Series, Physical Review Letters 100, 084102 (2008)).

Das Potenzverhalten der Kreuzkorrelation und der Fluktuation zweier Kann nun diagnostisch genutzt werden, um z. B. zu erkennen, ob zwei Geräte im Falle von Auffälligkeiten unabhängig voneinander fluktuieren, d. h. die Geräte wurden von sich aus auffällig, oder ob diese Fluktuationen ggf. von außen, z. B. einer Auffälligkeit in der Energieversorgung bzw. dem Hausnetz, welche die Fluktuation bestimmt, bestimmt sind. Insofern kann im Falle einer Auffälligkeit zwischen einem Defekt in einem Gerät, wobei nur ein Gerät auffällig ist, oder aber einer Störung von außen, bei der mehrere Geräte auffällig sind, ggf. bei durch das Hausnetz verursachten Störungen, unterschieden werden. Umgekehrt kann bei gleichzeitig zunehmenden Korrelationen der Fluktuationen verschiedener Geräte auf äußere Umstände, z. B. ein instabiles anfälliges Hausnetz, geschlossen und im Falle einer kollektiven Änderung der Fluktuation in der Geräte bzw. der einzelnen Stecker eine systematische Störung außerhalb der Geräte frühzeitig erkannt werden.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Kurze Beschreibung der Zeichnungen

Figur 1 zeigt eine Ausführung einer Steckeranordnung mit einem intelligenten Stecker in einer Prinzipskizze.
Figur 2 zeigt Details des intelligenten Steckers aus Figur 1.
Figur 3 zeigt anhand zweier Graphen eine Geräteerkennung.
Figur 4 zeigt in vier Graphen das Prinzip einer DFA.
Figur 5 zeigt in vier Graphen das Prinzip einer Schaden-Früherkennung.

### Ausführungsformen der Erfindung

Die Erfindung ist anhand von Ausführungsformen in den Zeichnungen schematisch dargestellt und wird nachfolgend unter Bezugnahme auf die Zeichnungen ausführlich beschrieben.

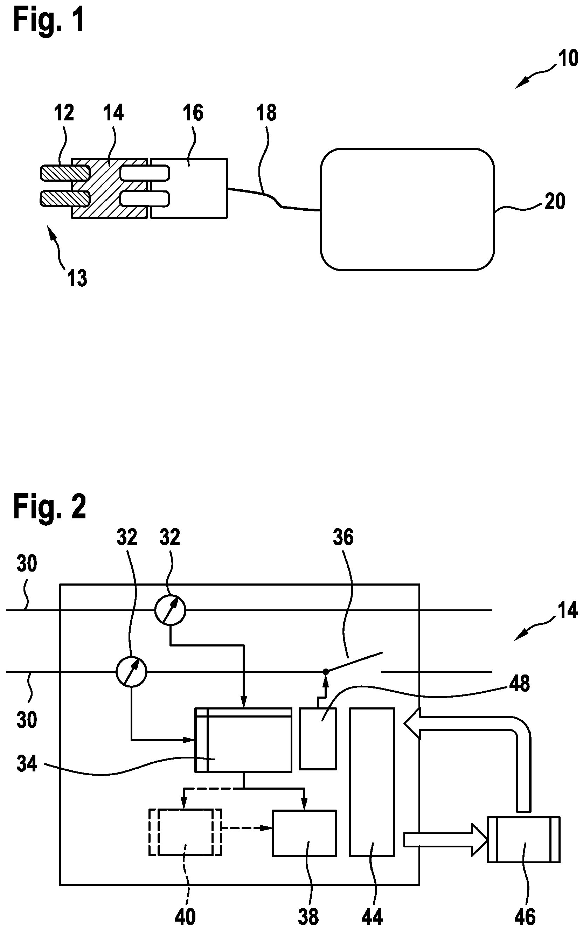

Figur 1 zeigt in einer Prinzipskizze eines Adapters, der insgesamt mit der Bezugsziffer 10 bezeichnet ist. Die Darstellung zeigt eine Steckdose 12 als Anschluss an ein Stromnetz 13, einen intelligenten Stecker 14, einen Gerätestecker 16, ein Gerätekabel 18 und ein Gerät 20.

Figur 2 zeigt den intelligenten Stecker 14 aus Figur 1 in größerem Detail. Die Darstellung zeigt Stromleitungen 30, die ggf. eine Leistungselektronik umfassen, Messvorrichtungen 32, einen integrierten Pufferspeicher 34 für Daten, eine Vorrichtung 36 zum Ein- und Ausschalten des Steckers 14, eine Kommunikationsschnittstelle 38, eine optionale integrierte Rechenschaltung 40, einen WLAN-Router 44 als eine mögliche Kommunikationsschnittstelle für ein intelligentes Hausnetz, ein Empfangsgerät 46, bspw. ein PC, Tablet, Smartphone, Smart Assistant, mit Cloud-Anbindung, und einen Prozessor 48 zum Bereitstellen von Gebersignalen, bspw. zum Abschalten des Steckers 14.

Der intelligente Stecker 14, der im Stromnetz 13 untergebracht ist und an dem Einrichtungen, nämlich der Gerätestecker 16, das Gerätekabel 18 und das Gerät 20, eingesteckt werden können, umfasst zweckmäßigerweise neben einer Vorrichtung zur Bereitstellung der für den Betrieb eines eingesteckten Geräts benötigte elektrische Leistung, nämlich den Stromleitungen 30, sowie einer Vorrichtung 36 zum Ein- und Ausschalten des Steckers über die Kommunikationsschnittstelle 38, wie bspw. eine WLAN-Einbindung, mindestens eine Messvorrichtung 32 zum Erfassen von insbesondere zeitlich hochaufgelösten Signalen, die es ermöglichen, auch Fluktuationen in den Signalverläufen aufzulösen sowie eine Datenkommunikationsschnittstelle, in diesem Fall dem WLAN-Modul bzw. Router 44 zum Weiterleiten dieser Daten sowie optional dem integrierten Speicher 34 zum ggf. Zwischenspeichern der aufgenommenen Daten.

Der Stecker 14 kann eine Rechenschaltung 40 oder einen Rechenprozessor aufweisen, die bzw. der die benötigten Rechenschritte für die Signalanalyse lokal ausführen kann. Alternativ kann die Signalanalyse auch außerhalb des Steckers 14, wenn bspw. eine Datenübertragung auf das Empfangsgerät 46, bspw. einen angebundenen Rechner mit entsprechender Software, oder über die Nutzung eines entsprechend erweiterten Cloud-Service durchgeführt werden. Aktionen, wie z. B. das Ein- oder Ausschalten, insbesondere bei besonderen Vorkommnissen, werden über den integrierten Prozessor 48 im Stecker 14 gesteuert.

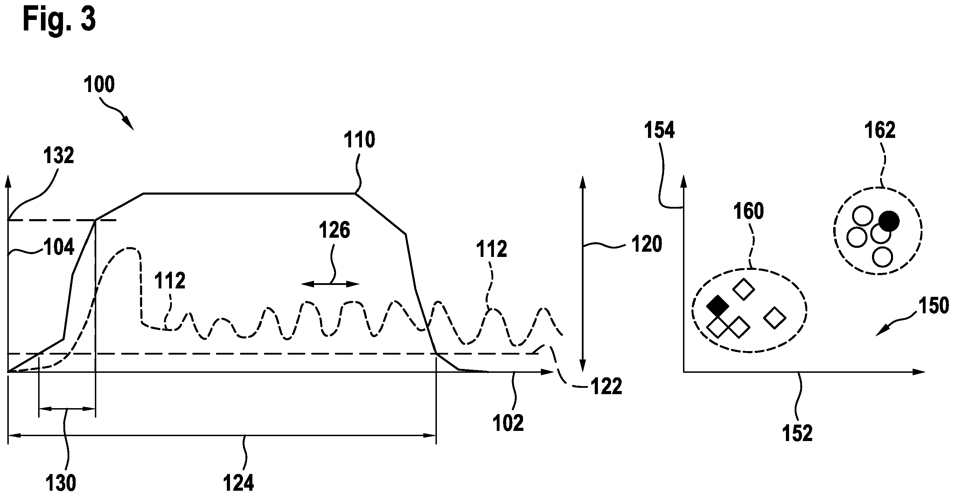

Figur 3 zeigt in einem ersten Graphen 100, an dessen Abszisse 102 die Zeit t und an dessen Ordinate 104 die Größe x aufgetragen ist, ein erstes zeitliches Profil 110 der Größe x und ein zweites zeitliches Profil 112 der Größe x. Zu beachten ist, dass je nach Gerät oder Geräteklasse unterschiedliche zeitliche Profile in der gemessenen Größe x erhalten werden. Die Darstellung zeigt weiterhin eine maximale Amplitude A 120, ein Wert 122, dessen Überschreitung als Wertüberschreitung bezeichnet wird. Die zeitliche Dauer Δt 124 durch das erste Profil 110 ist ebenfalls angezeigt. Weiterhin sind eine Periodendauer T 126 des zweiten Profils 112 und Ansprechzeit τ 130 des ersten Profils 110 in Bezug zu einem Wert 132 der Größe x angezeigt. Aufgrund von Merkmalen, wie hier der Amplitude bzw. dem Maximalwert A 120, der Wertüberschreitungsdauer Δt 124, der Ansprechzeit τ 130 oder bei periodischen Signalen, wie dem zweiten Profil 112, die Periodendauer T 126 bzw. eine Frequenz, können diese in einer Merkmalsextraktion bestimmten Geräteklassen zugeordnet werden.

Figur 3 zeigt weiterhin einen zweiten Graphen 150, an dessen Abszisse 152 die Amplitude A 120 und an dessen Ordinate Ansprechzeit τ 130 aufgetragen ist, eine exemplarische Darstellung von Merkmalsvektoren mit zwei Komponenten für zwei unterschiedliche Geräteklassen 160, 162.

Signale, die beim erstmaligen Einstecken eines Geräts aufgezeichnet werden, wie dies in Figur 3 verdeutlicht wird, werden zweckmäßigerweise mit bereits bekannten Daten aus z. B. einer Datenbank mit angelernten Mustern verglichen und es wird eine Ad-Hoc-Zuordnung vorgenommen, die der Nutzer im Falle einer Fehlinterpretation manuell ändern kann. Durch eine Änderung kann zudem, nach ggf. erfolgter Plausibilisierung, der Trainingsdatensatz in der Datenbank erweitert werden. Eingelernte Muster werden wiedererkannt und im Falle eines Gerätewechsels an dem Stecker die richtige Zuordnung getroffen.

Beim Betreiben des Geräts an dem Stecker werden fortlaufend die Signale kontinuierlich und zeitdiskret aufgezeichnet und für die Analyse bereitgestellt. In der Analyse wird zum einen der allgemeine, bspw. geglättete zeitliche Verlauf bewertet, um über bestimmte Muster zum einen das Gerät selbst wiederzuerkennen zum anderen aber auch dem Gerät spezifische Betriebspunkte zu erkennen. Es wird hierzu auf Figur 3, erster Graph 100 verwiesen. Dies kann über gängige Merkmalsextraktions- und Mustererkennungsalgorithmen, wie bspw. einer Hauptkomponentenanalyse, oder z. B. auch durch ein sogenanntes Deep-Learning mit neuronalen Netzen geschehen. Es wird hierzu auf Figur 3, zweiter Graph 150 verwiesen.

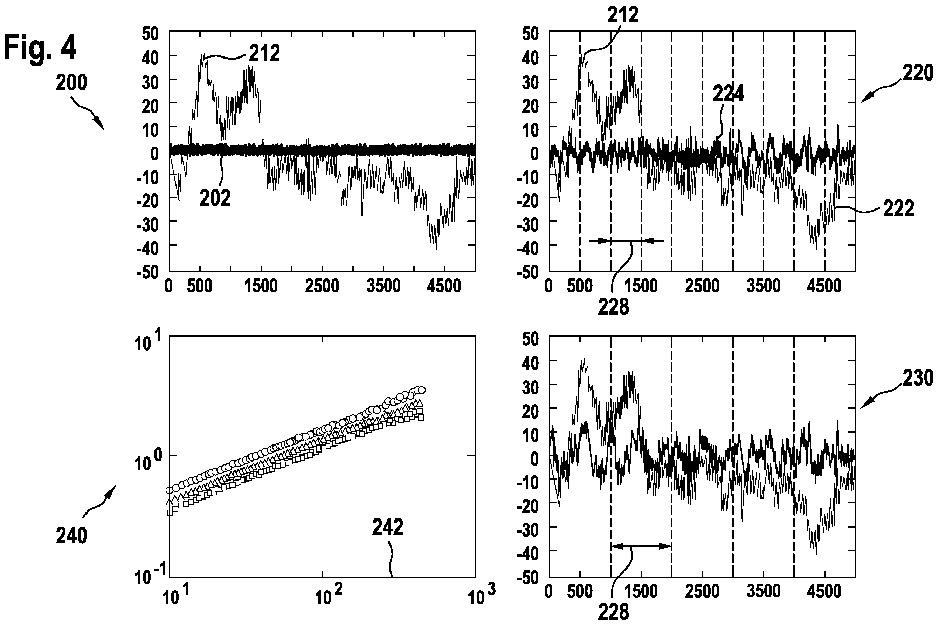

Im Weiteren kann darüber hinaus die Fluktuation der Signale, die im Allgemeinen instationär sein werden, mit Fluktuationsanalysemethoden wie bspw. der trendbereinigten Fluktuationsanalyse DFA (engl. Detrended Fluctuation Analysis auf Korrelationen untersucht werden. Es wird hierzu auf Figur 4 verwiesen.

Figur 4 verdeutlicht in vier Graphen das Prinzip einer DFA, wobei dies hier exemplarisch für den Fall eines mittelwertstabilen unkorrelierten Rauschens vorgenommen wird. In einem ersten Graphen 200 ist der Verlauf eines Rohsignals y(t) 202 gezeigt, bspw. ein Widerstand über die Zeit, der trendbehaftet sein kann. Dieses Signal wird kumuliert, d. h. aufsummiert, so dass sich eine kumulierte Reihe 212 ergibt, deren Verlauf in dem Graphen 200 dargestellt ist. Anschließend wird die kumulierte Reihe 212, was in einem zweiten Graphen 220 dargestellt ist, sukzessive in Fenster der Breite s segmentiert und in jedem Fenster wird die kumulierte Reihe 212 durch ein Polynom n-ten Grades angepasst. Diese Polynome sind durch eine Kurve 222 dargestellt. Es wird dann ein Residuum 224 zwischen kumulierter Reihe 212 und Polynom 222 ermittelt, und zwar durch Subtraktion kumulierte Reihe 212 minus Polynom 222 und die Fluktuation des Residuums 224 in jedem Fenster der Breite s 228 berechnet und über die Anzahl der Fenster gemittelt. Es ergibt sich hierfür ein Datenpunkt. Dies wird für verschiedene Fensterbreiten wiederholt, wie in einem dritten Graphen 230 zu sehen ist. Das Ergebnis wird als Funktion der Fensterbreiten aufgetragen. Es wird hierzu auf einen vierten Graphen 240 verwiesen, an dessen Abszisse 242 die Fensterbreite s aufgetragen ist. Die sogenannte Fluktuationsfunktion F⁽ⁿ⁾(s) zeigt dann im Langzeitverhalten ein Potenzgesetz F⁽ⁿ⁾(s) α s^{α} und der Exponent des Langzeitverhaltens α kann zur Identifikation von Langzeitkorrelationen und damit ggf. von zugrundeliegenden Prozessen, wie bspw. Diffusions- und/oder Reaktionsprozessen, die z. B. spezifisch für einen vorliegenden zu detektierenden Stoff sein kann, herangezogen werden. Bei dem Beispiel in Figur 4 ergibt sich für α ein Wert von 1/2.

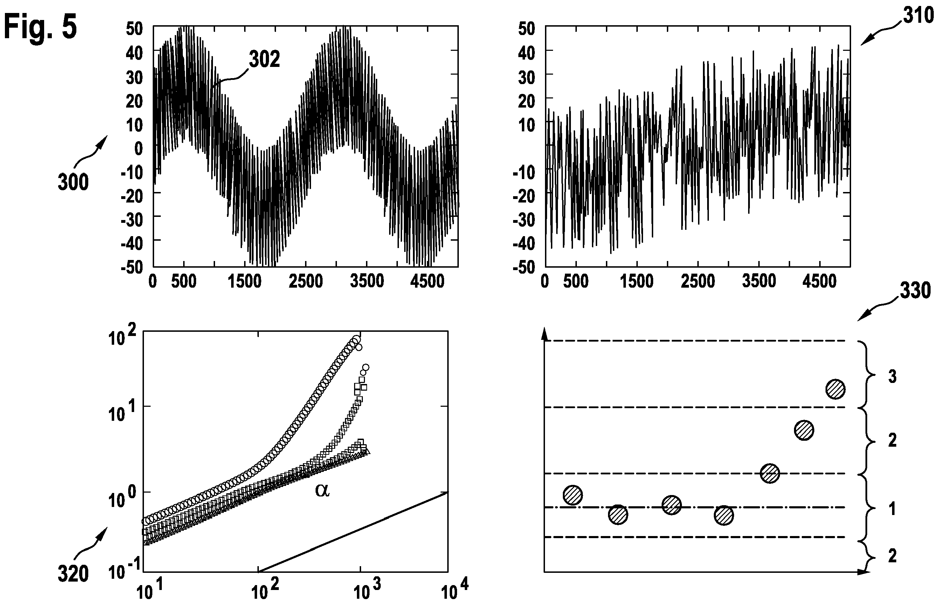

Zu beachten ist, dass Änderungen in den Korrelationen von Wechseln zwischen Betriebspunkten aber auch von systematischen Änderungen herrühren können, die auf eine Schädigung schließen lassen. Diese Veränderungen können dabei ebenso als ein weiteres Merkmal trainiert werden, um bspw. zwischen Betriebspunktwechseln und Korrelationsänderungen, die mit einem beginnenden Schaden zusammenhängen, zu unterscheiden. Ziel ist es, mit einem Überwachen der Fluktuationen eine Früherkennung von potenziellen Schäden als Funktion bereitzustellen. Es wird in diesem Zusammenhang auf Figur 5 verwiesen.

Figur 5 zeigt in vier Graphen eine Prinzipskizze einer Schadenfrüherkennung. Hierfür wird ein Rohsignal 302, dessen Verlauf in einem ersten Graphen 300 wiedergegeben ist und mit einem Trend, bspw. einer Schwingung, behaftet sein kann, aufgezeichnet. Über geeignete Methoden, wie bspw. eine DFA, wird die Fluktuation vom Trend separiert, siehe hierzu im Detail einen zweiten Graphen 310, und das Skalenverhalten, wie einem dritten Graphen 320 zu entnehmen ist, z. B. über eine DFA mit verschiedenen Ordnungen n zur Trendbereinigung ermittelt. Der zweite Graph 310 ist lediglich ein Ausschnitt aus dem ersten Graphen 300, um die Fluktuation deutlicher zu zeigen.

Der Exponent α ist ein Maß über die im Rauschen vorhandenen Langzeitkorrelationen. Für bestimmte Betriebspunkte können bezüglich des Exponenten α bestimmte Bereiche, siehe hierzu einen vierten Graphen 330, an dessen Ordinate α aufgetragen ist, einem typischen und ordnungsgemäßen Betrieb (1) entsprechen.

Wird beobachtet, dass der Exponent diesen Bereich verlässt oder stark schwankt, so kann ggf. innerhalb weiterer Bereichsgrenzen (2) ein drohender Schaden frühzeitig erkannt und noch vermieden werden. Im Schadensfall ist der Exponent hingegen in einen kritischen Bereich (3) gelangt.

## Patentansprüche

1. Verfahren zum Überwachen eines elektrischen Geräts (20), das über einen Adapter (10) mit einem Stromnetz (13) verbunden ist, wobei mindestens ein Rohsignal (202, 302), das eine Zeitreihe von Messwerten repräsentiert und von dem Adapter (10) bereitgestellt wird, mittels einer trendbereinigten Fluktuationsanalyse (DFA) ausgewertet wird, so dass ein trendbereinigtes Signal erhalten wird, das wiederum ausgewertet wird, um eine zeitliche Veränderung der Fluktuation der Messwerte zu erkennen und in Abhängigkeit von einer Auswertung der zeitlichen Veränderung das elektrische Gerät (20) zu überwachen.

2. Verfahren nach Anspruch 1, bei dem eine erkannte zeitliche Veränderung in der Fluktuation dazu genutzt wird, um auf zukünftige Ereignisse, die das Gerät (20) betreffen, zu schließen.

3. Verfahren nach Anspruch 1 oder 2, bei dem in Abhängigkeit von dem zukünftigen Ereignis geeignete Maßnahmen eingeleitet werden.

4. Verfahren nach einem der Ansprüche 1 bis 3, bei dem mehrere Rohsignale (202, 302) des Geräts (20) ausgewertet werden.

5. Verfahren nach einem der Ansprüche 1 bis 4, bei dem Rohsignale (202, 302) von mehreren Geräten (20) ausgewertet werden.

6. Verfahren nach Anspruch 4 oder 5, bei dem eine Kreuzkorrelation durchgeführt wird.

7. Verfahren nach einem der Ansprüche 1 bis 6, bei dem das mindestens eine Rohsignal (202, 302) kumuliert wird, so dass sich eine kumulierte Reihe (212) ergibt, die kumulierte Reihe (212) sukzessive in Fenster der Breite s (228) segmentiert wird und in jedem Fenster die kumulierte Reihe (212) durch ein Polynom (222) n-ten Grades angepasst wird, dann ein Residuum (224) zwischen der kumulierten Reihe (212) und dem Polynom (222) ermittelt wird und die Fluktuation des Residuums (224) in jedem Fenster der Breite s (228) berechnet und über die Anzahl der Fenster gemittelt wird, wobei dies für verschiedene Fensterbreiten wiederholt wird, so dass eine Fluktuationsfunktion F⁽ⁿ⁾(s) ermittelt wird, die im Langzeitverhalten ein Potenzgesetz F⁽ⁿ⁾(s) α s^{α} wiedergibt und der Exponent α ausgewertet wird.

8. Verfahren nach einem der Ansprüche 1 bis 8, das die Schritte des Messens und des Weiterleitens der Messwerte umfasst.

9. Anordnung zum Überwachen eines elektrischen Geräts (20), die zur Durchführung eines Verfahrens nach einem der Ansprüche 1 bis 8 eingerichtet ist.

10. Anordnung nach Anspruch 9, die als intelligenter Stecker (14) eines Adapters (10), der dem elektrischen Gerät (20) zugeordnet ist, ausgebildet ist.
